# EUROPEAN PATENT APPLICATION

(11) **EP 1 435 647 A1**
(43) Date of publication of application: **07.07.2004**
(21) Application number: 02425806.3
(22) Date of filing: 30.12.2002
(51) Int. Cl.: H01L 21/331, H01L 21/60

(54) **Method for forming structures self-aligned with each other on a semiconductor substrate**

(71) Applicant: STMicroelectronics S.r.l., 20041 Agrate Brianza (Milano) (IT)
(72) Inventor: Baldi, Livio, 20041 Agrate Brianza (Milano) (IT); Clementi, Cesare, 21052 Busto Arsizio (Varese) (IT); Pavan, Alessia, 23807 Merate (Lecco) (IT)
(74) Representative: Ferrari, Barbara

(57) **Abstract**

A method for forming structures self-aligned with each other on a semiconductor substrate (1), comprising the following steps:
- forming, on the semiconductor substrate (1), first regions (3,12) of a first material projecting from the semiconductor substrate (1);
- forming, over the whole of the semiconductor substrate (1), a protective layer (7,16) of a second material selective with respect to the first material;
- removing the protective layer (7,16) to expose said first regions (3,12) through a planarizing step;
- etching said first regions (3,12) to expose said semiconductor substrate (1), and forming second regions (7a,16a) projecting from the substrate (1) of said protective layer.

Advantageously, spacers are formed on the sidewalls of the first regions.

## Description

### Field of Application

The present invention relates to a method for forming structures self-aligned with each other on a semiconductor substrate.

Although not limited to, the invention relates in particular to a method for forming, on a semiconductor substrate, two implanted contiguous regions, such as an extrinsic base region, an intrinsic base region, and an emitter region of a bipolar transistor, the complement of this description dealing with this field of application for convenience of explanation only.

### Prior Art

As is well known, aligning the structures incorporated in an integrated circuit with each other is one of the main drawbacks that affects the final dimension of electronic devices formed on a semiconductor substrate, affecting directly the increase of the area of the components and as a consequence the processing cost.

The mutual placement of the components of a semiconductor integrated circuit need to follow some dimensional rules to prevent unwanted interaction among independent circuit components, such rules being tied to hardware limitations of the lithographic appliances used for defining the circuit components themselves.

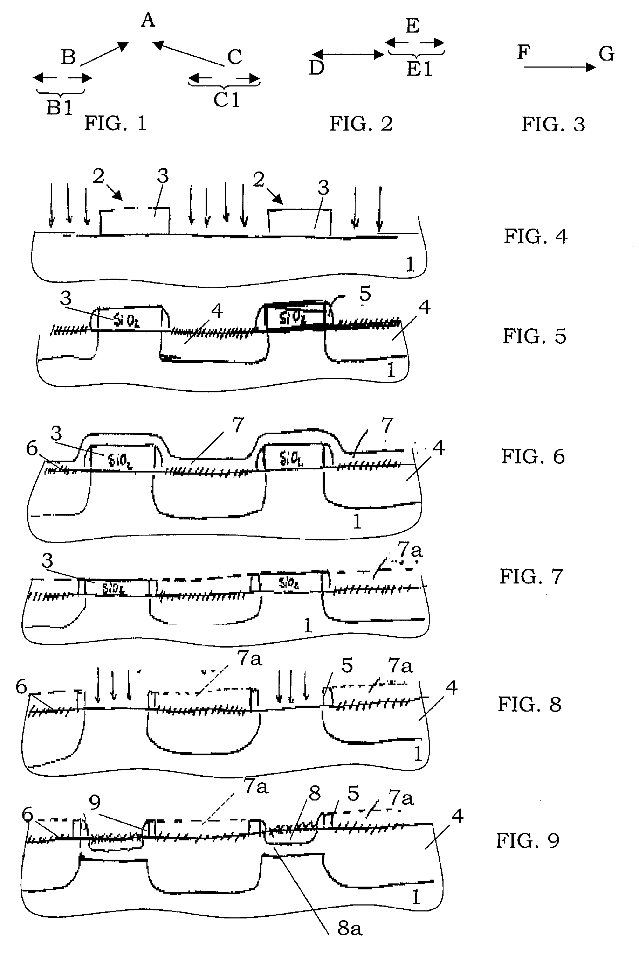

To achieve a desired mutual placement of the different circuit components, it is usually used a specially patterned structure or template, as an absolute reference point, in relation with which all the components of a device are positioned . When two elements B and C are to be placed in a definite mutual relationship, the need for a fixed reference point A involves a security double space B1, C1, as shown in Figure 1.

On the other hand, if two elements D, E can be directly aligned without passing through an absolute reference, occupancy space saving is obtained, as shown in Figure 2, and only one security space E1 is needed.

If one of the two elements F, G can be used as a boundary (mask) for patterning the other, space requirement is minimized, since there is no more need for wasting space in order to guarantee safety to the mutual alignment, as shown in Figure 3.

This latter shown configuration is called self-alignment.

This self-alignment technique has been used, where possible, since the first steps of microelectronics. Self-aligned structures may be, for instance, semi-withdrawn isolation of the LOCOS (Local Oxidation of Silicon) type, self-aligned source lines of the memory cell of the SAS type (Self-Aligned Source), self-aligned contacts SACs (Self-Aligned Contacts), and floating gate regions of the stacked gate memory cells.

A first prior method for forming self-aligned structures is commonly known as the "positive" self-alignment method.

In positive self-alignment a first structure is defined, which has such a physical nature and texture as to serve as a mask for the second structure.

Doping the source and drain regions of a MOS transistor, being these regions self-aligned with respect to an existing gate region of polycrystalline silicon, provides a typical example.

Another example is the formation of SAS in flash memories, where the polycrystalline silicon layer of the (pre-patterned) wordlines is used as a mask for removing the oxide layer from the source region. A further example is the definition of a floating gate region in non-volatile memories, where the second (pre-patterned) polysilicon level is used as a mask for removing the first polysilicon level.

A second prior method for forming self-aligned structures is commonly known as the "negative" self-alignment method.

In the "negative" self-alignment, on the contrary, the structure which could work as a mask (usually a deposited o grown up layer) is arranged above the structure to be self-aligned.

A typical example of the latter is LOCOS isolation, where a layer of thick field oxide overlies the isolation implant. A sacrificial protective layer of silicon nitride is employed in this technique to mask off the active areas of the isolation implant, and later the growth of the field oxide layer as well.

While being advantageous from several points of view, the last-mentioned method has some drawbacks. The method involves heavy thermal treatments, which may affect previously defined components or result in undesired diffusions through preexisting structures or previously created junctions.

In addition, this method uses the diffusion of one species through another (e.g., O₂ through Si). Since the process is isotropic, diffusion will also occur sideward, under the edge of the nitride which protects the active area, resulting in the active area being partly oxidized and creating an oxide area that is thinner than the isolation layer and not suitable for the active elements.

In this case, the active area is undesirably offset from its negation, which is linked to the mechanism forming the two structures and that cannot be neither controlled nor modulated according to the user's demands.

Also isolation of the STI (Shallow Trench Isolation) type, sharing the same isolation scheme as the LOCOS one, has the same drawbacks related to thermal treatments. In fact STI involves a the deposition of the isolating oxide layer rather than thermal growth.

Thus, the self-alignment technique is advantageously applied to structures that are physically present on the substrate, such as the isolation nitride layers, the gate region for SAS, or the floating gate region etching.

The above prior methods cannot be applied, instead, to structures that, like the implanted regions, do not leave significant marks of their presence on the silicon, which, after removal of the photoresist usually used to identify them, are no longer discernible (or only in a very difficult and little repeatable way) from non-implanted adjacent regions. Further on, negative self-alignments where limits of the LOCOS technique cannot be accepted, i.e. heavy thermal treatments, little controlled sideward diffusion, cavities in silicon. Prior approaches to provide configurations of this type use purely lithographic methods, which result in the wasting space problem connected with the alignment restrictions already described.

The underlying technical problem of this invention is to provide a method for forming, on a semiconductor substrate, devices or device components being self-aligned with each other and having such structural features as dedicated thermal treatments to be used as little as possible, thus overcoming the limits and drawbacks of the devices according to the prior art.

### Summary of the Invention

The solutive idea on which this invention stands is that of forming and patterning a first plurality of structures of a first material on a semiconductor layer, forming a protective layer of a second material which is selective with respect to the first on this plurality of structures, and planarizing this protective layer to expose the plurality of structures and obtain a second plurality of structures self-aligned with each other. Advantageously, spacers are formed on both the first and the second structures.

On the basis of this idea, the technical problem is solved by a method as previously indicated, and as defined in the characterizing portions of Claims 1 and 17.

The features and advantages of the method according to the invention should become apparent from the following description of an embodiment thereof, given by way of non-limitative example with reference to the accompanying drawings.

### Brief Description of the Drawings

In the drawings:
Figures 1 to 3 show schematically various types of mutual placement of circuit elements,
Figures 4 to 9 are respective schematic sectional views of a portion of an integrated circuit during the successive steps of a first embodiment of the method according to the invention,
Figures 10 to 15 are respective schematic sectional views of a portion of an integrated circuit during successive steps of a second embodiment of the method according to the invention.

### Detailed Description

A method for forming, on a semiconductor substrate, of structures self-aligned with each other is described here below with reference to the drawings.

The method of the invention comprises a succession of processing steps. The steps described hereinafter are not a complete processing flow for the manufacturing of integrated circuits. This invention can be implemented in combination with current integrated circuit manufacturing techniques, and only those currently used steps, necessary for the understanding of the invention, will be described.

The schematic drawings of portions of an integrated circuit undergoing manufacturing are not drawn to scale, but rather to illustrate major features of the invention.

In particular, the method for forming self-aligned structures on a semiconductor substrate 1, according to the invention, provides the formation, on the semiconductor substrate 1, of first regions 3, 12 of a first material, these regions projecting from said semiconductor substrate 1. This first material may be an oxide layer.

A protective layer 7, 16 of a second material which is selective with respect to the first material, e.g. a nitride layer, is then formed on the whole of said semiconductor substrate 1.

Thereafter, the protective layer 7, 16 is planarized to expose the first regions 3, 12 and form second regions 7a, 16a of the protective layer 7, 16, projecting from the substrate 1 and extended between the first regions 3, 12.

Two pluralities of regions 3, 3a and 12, 12a are thus defined which are aligned to each other.

By selectively removing the first plurality of regions 3, 12, additional regions can be defined which are aligned to the second plurality of regions 7a, 16a, by using the second plurality of regions 7a, 16a as a mask.

Advantageously in this invention, spacers 5, 14 are patterned on the sidewalls of the first plurality of regions 3, 12.

Thus, the width of the regions 7a, 16a being defined by the protective layer 7 is varied to meet design requirements of the structures to be formed.

In one embodiment of the invention, regions 3, 12 are formed on the substrate 1 and spacers 5, 14 on the sidewalls of the first regions 3, 12.

Once the protective layer 7, 16 is formed and the resultant structure is planarized, the spacers 5, 14 are removed, thus forming a plurality of regions 3, 7a and 12, 16a projecting from the substrate and separate from each other.

The distance between said regions 3, 7a and 12, 16a is set by the thickness of the spacers 5, 14.

An embodiment of the method according to the invention, wherein two contiguous implanted areas, such as an extrinsic base region, intrinsic base region and emitter region of a bipolar transistor are formed, will now be described.

A first layer 2, e.g. an oxide layer, is deposited on a semiconductor substrate 1, e.g. a silicon substrate. The first layer 2 is then patterned by using conventional lithographic and etching techniques for forming regions 3 projecting from the semiconductor substrate 1.

Advantageously, spacers 5 of a different material from that of the first layer 2, e.g. silicon nitride, are formed on the sidewalls of the regions 3 that have been used for masking the first implant.

A first implanting step is then carried out to form a first region or junction 4, as shown in Figure 5.

The first implanted region 4 is self-aligned with respect to the regions 3, and can be used for forming an extrinsic base region of a bipolar transistor.

Advantageously, a metal layer 6, e.g. of a transition metal such as Titanium, Cobalt, or Nitride, is formed on the substrate 1. The whole device then undergoes a thermal treatment so that the metal layer 6, reacting with substrate 1 not covered with the regions 3 and the spacers 5, forms a silicide layer suitable for lowering the layer resistivity.

A second layer 7, having selective etching properties with respect to the first layer 2, is then formed all over the substrate 1.

For example, the second layer 7 is a silicon nitride layer deposited through CVD (Chemical Vapor Deposition), which results in the regions 5 that projecting from the substrate 1 being well covered.

According to the invention, the layer 7 is then removed to expose the first layer 2 as shown in Figure 7.

Regions 7a of the second layer 7 are thus bounded between regions 3 projecting from the substrate.

Advantageously, this removing step is a planarizing step carried out with a CMP technique, for example.

At this stage, the first regions 5 are etched away selectively, for instance by etching with a hydrofluoric acid solution.

By applying this selective etching, the spacers 5 and regions of the second layer 7 left on the substrate 1 are not harmed.

A second implanting step is then carried out to form implanted regions 8, 8a where, for example, respective emitter and base junctions 8, 8a of a bipolar transistor may be formed.

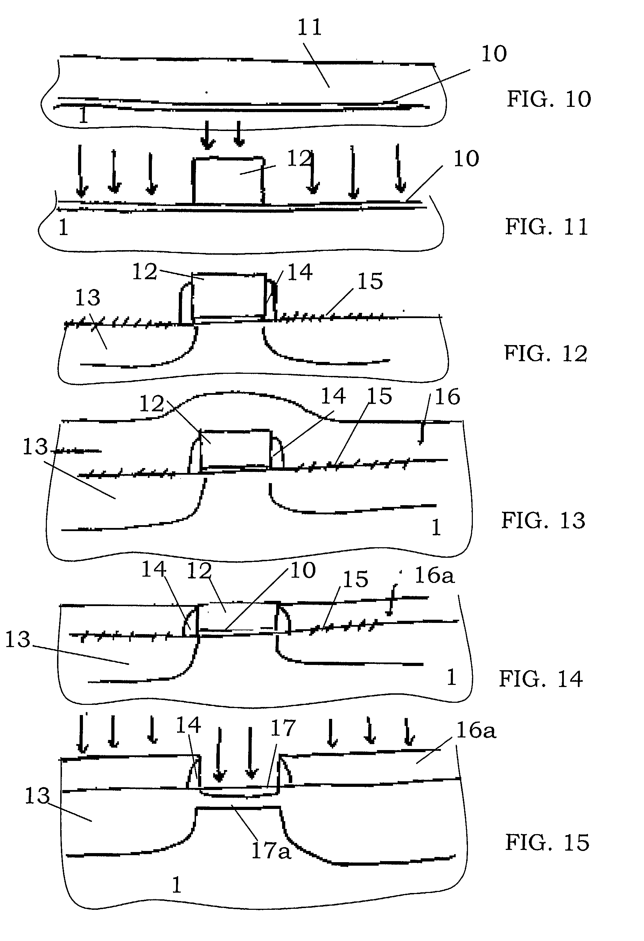

This second implanting step is screened off in the areas in which the first region 4 is there already by the second protective layer 7, as shown in Figure 9.

The regions 7a of layer 7 are then selectively etched away with respect to the substrate 1, by using warm hydrofluoric acid, for example.

Advantageously, these regions 7a are used in subsequent processing steps, e.g. to complete the device and to establish self-aligned contact on the emitter, in case of a bipolar transistor.

Different material pairs may be used for forming the regions 5 and protective layer 7, provided that they can be deposited at low temperature and always planarized with the CMP technique, and be selectively removable one another and with respect to the substrate.

For example, the oxide and nitride layers could be exchanged, or a polycrystalline silicon deposited on a thin oxide layer could be used as first layer 2, and an oxide or nitride layer 7 used as second layer 7.

It can also be appreciated that the mutual placement of the first 4 and second junction 8 could be changed to suit the functional requirements of the device, by providing spacers 5 of a suitable length and appropriate material before the first or the second implanting step is applied.

Advantageously, second spacers 9 are formed on the sidewalls of the first spacers 5. The second spacers 9 may be formed by means of a layer of Ti, Co, or Ni silicide.

The width of these spacers 9 can be modulated by means of the amount of deposited material and the etching extent, thus obtaining a separation between the first spacers 5 that can easily reach sub-lithographic dimensions.

Shown in Figures 10 to 15 is a second embodiment of the inventive method.

A first, thin dielectric layer 10 and a first, thick protective layer 11, e.g. 0.5 to 1 µm thick, are formed on a semiconductor substrate 1. The first dielectric layer 10 may be an oxide layer whereas the second the first protective layer 11 may be a nitride layer, as shown in Figure 10.

The first protective layer 11 is then patterned to form projecting regions or pillars 12, leaving the first dielectric layer 11 untouched as shown in Figure 11.

Advantageously, this patterning step is performed with a conventional technique and subsequent etching step through RIE (Reactive Ion Etching).

Advantageously, spacers 14, made of a selective material with respect to the material of the pillars 12, are formed on the sidewalls of the pillars 12 that have been used for masking the first implant.

A first, heavy implanting step is then carried out all over the substrate 1 to form a first implanted region 13.

The first implanted region 13 is self-aligned with respect to the pillars 12, and may be used to form the extrinsic base region of a bipolar transistor.

Thermal treatments for activating the dopant to complete the first implanted region 13 are then performed.

By providing the spacers 14, potential problems of sideward diffusion are mitigated.

Advantageously, a metal layer 15, e.g. of a transition metal such as Ti, Co, Ni, is deposited over the whole device. The whole device then undergoes a thermal treatment so that the metal layer 15, reacting with the substrate 1 not covered by the pillars 12, forms a silicide layer apt to reduce the layer resistivity.

According to the invention, a protective layer 16 is deposited on the whole substrate 1. This dielectric layer 16 may be a thick layer of pre-metal isolation oxide as shown in Figure 13.

This is followed by a planarizing step, e.g. through CMP, to expose the pillars 12.

Regions 16a of the second layer 16 are thus bounded between the regions 3 projecting from the substrate.

The pillars 12 are then etched away selectively. Where the pillars 12 are made of silicon nitride, the selective etching may be performed either with warm hydrofluoric acid or a highly selective plasma.

The layer 10 is then etched away from the substrate 1, by using a buffered solution, for example.

A second and a third implanting steps are then carried out to provide a second 17 and a third 17a implanted regions, the latter 17a being fully embedded in the second region 17 as shown in Figure 15.

The second and third implanted regions 17 and 17a may be used as an intrinsic base region and an emitter region for a bipolar transistor.

The device is then completed through conventional processing steps. Particularly as far as bipolar transistors are concerned, the contact is formed conventionally.

In this embodiment, the bipolar transistor base and emitter regions are self-aligned to the contact of the emitter region, with the etch prevented from harming the surface of the substrate 1. Furthermore, the thermal treatments are avoided, these being associated with the formation of the extrinsic base region, which alter the profile of the emitter region.

Although the manufacturing method relates to the manufacturing of bipolar transistors, the method according to the invention can be used, for example, to obtain a polysilicon area self-aligned to an implant, , e.g. a deep anti-punch-through implant, which is not to end beneath the source-drain regions of a MOS transistor in order to reduce the junction capacitance.

In summary, the method of the invention allows self-aligned structures to be defined, avoiding the cavities in the substrate 1 and without involving any heavy thermal treatments.

In particular, the structures formed with this method are used as masks for the layer where they have been formed, or they are used themselves as active structures in an integrated circuit in which they are embedded.

Where implanted regions are provided, the regions may be spaced apart as desired, even below lithography limits, in a controlled manner.

## Claims

1. A method for forming structures self-aligned with each other on a semiconductor substrate (1), comprising the following steps:
- forming, on the semiconductor substrate (1), first regions (3,12) of a first material projecting from said semiconductor substrate (1);
- forming, on the whole of said semiconductor substrate (1), a protective layer (7,16) of a second material, said second material being selective with respect to said first material;
- removing said protective layer (7,16) to expose said first regions (3,12) through a planarizing step,;
- etching said first regions (3,12) to expose said semiconductor substrate (1), and forming second regions (7a,16a) projecting from the substrate (1) of said protective layer (7,16).

2. A method for forming structures self-aligned with each other according to Claim 1, **characterized in that** it comprises the following steps:
- forming first spacers (5,14) of a second selective material with respect to the first material on the sidewalls of said first regions (3,12), before said protective layer (7,16) is formed.

3. A method for forming structures self-aligned with each other according to Claim 2, **characterized in that** it comprises the following steps:
- etching said first regions (3,12) to expose said semiconductor substrate (1), and forming regions (7a,16a) projecting from the substrate of said protective layer.

4. A method for forming structures self-aligned with each other according to Claim 1, **characterized in that** it comprises the following steps:
- carrying out an implanting step on the whole semiconductor substrate (1) to form, on said semiconductor substrate (1), first implanted regions (4,13) adjacent to said first regions (3,12), before the protective layer (7,16) is formed.

5. A method for forming structures self-aligned with each other according to Claim 1, **characterized in that** it comprises the following steps:
- carrying out an implanting step on the whole of said semiconductor substrate (1) to form, on said semiconductor substrate (1), implanted regions (8,8a;17,17a) adjacent to said second regions (7a,16a).

6. A method for forming structures self-aligned with each other according to Claim 2, **characterized in that** it comprises the following steps:
- forming second spacers (9) on the sidewalls of said first spacers (5).

7. A method for forming structures self-aligned with each other according to Claim 2, **characterized in that** said first spacers (5,14) are made of a third material selective with respect to the first material.

8. A method for forming structures self-aligned with each other according to Claim 6, **characterized in that** said second spacers (9) are made of a fourth material selective with respect to the first material.

9. A method for forming structures self-aligned with each other according to Claim 1, **characterized in that** said planarizing step is carried out by using a CMP technique.

10. A method for forming structures self-aligned with each other according to Claim 1, **characterized in that** said first material is a silicon oxide and said second material is silicon nitride.

11. A method for forming structures self-aligned with each other according to Claim 1, **characterized in that** said first material is silicon nitride and said second material is a silicon oxide.

12. A method for forming structures self-aligned with each other according to Claim 1, **characterized in that** it comprises the following steps:
- forming an additional protective layer (10) on the whole of said substrate (1) before forming said first regions (3,12) of a fifth material selective with respect to the first material.

13. A method for forming structures self-aligned with each other according to Claim 8, **characterized in that** said third and fourth materials are silicon nitride.

14. A method for forming structures self-aligned with each other according to Claim 8, **characterized in that** said fifth material is silicon oxide.

15. A method for forming structures self-aligned with each other according to Claim 1, **characterized in that** said first implanted regions (4,13) are extrinsic base regions of a bipolar transistor, and that said at least second regions (8,8a;17,17a) are bipolar transistor emitter and base junctions (8,8a), respectively.

16. A method for forming structures self-aligned with each other according to Claim 2, **characterized in that** it comprises the following steps:
- forming, on said semiconductor substrate (1), a metal layer (6,14) after said first spacers (5,14) are formed, and subsequent thermal treatment to selectively form a silicide layer on the substrate portions, that are exposed from said first regions (3,12), and said first spacers (5,14).

17. A method for forming structures self-aligned with each other on a semiconductor substrate (1), comprising the following steps:
- forming, on the semiconductor substrate (1), first regions (3,12) of a first material projecting from said semiconductor substrate (1);
- forming first spacers (5,14) of a second selective material with respect to the first material on the sidewalls of said first regions (3,12), before said protective layer (7,16) is formed;
- forming, over the whole of said semiconductor substrate (1), a protective layer (7,16) of a third material selective with respect to the second material;
- removing said protective layer to expose said first regions (3,12) through a planarizing step;
etching said first spacers (5,14) to expose said semiconductor substrate (1), and forming regions (7a) projecting from the substrate of said protective layer.
